# EUROPÄISCHE PATENTANMELDUNG

(11) **EP 0 954 098 A2**
(43) Veröffentlichungstag der Anmeldung: **03.11.1999**
(21) Anmeldenummer: 99105332.3
(22) Anmeldetag: 16.03.1999
(51) Int. Cl.: H03K 17/96, E05B 49/00

(54) **Erkennungssystem und Schaltvorrichtung**

(30) Priorität: 03.04.1998 AU PP277798
(71) Anmelder: ROBERT BOSCH GMBH, 70442 Stuttgart (DE)
(72) Erfinder: Pavatich, Gianfranco, 3038 Keilor Downs, Vic (AU); Gangemi, Daniel Phillip, 3095 Research, Vic (AU)

(57) **Zusammenfassung**

Ein Erkennungssystem (1), einschließlich einer Schaltvorrichtung (100) mit einem Leiter (2), der Bestandteil eines Kondensators (3) mit variabler, von der Nähe einer Person abhängiger Kapazität ist, und einen Detektor (200) zur Erfassung von Veränderungen in der Kapazität und zum Erzeugen eines Ausgangssignals, das die Nähe einer Person relativ zu dem Leiter anzeigt, wobei die Schaltvorrichtung des weiteren ein Halteteil (13) umfaßt, welches dafür ausgelegt ist, den Leiter an dem Türgriff (20) zu befestigen, wobei in dem Halteteil auch ein mechanischer Schalter zur Betätigung seitens einer den Türgriff ergreifenden Person angeordnet ist, um zusätzlich oder alternativ die Nahe der Person anzuzeigen.

## Beschreibung

### BEREICH DER ERFINDUNG

Die vorliegende Erfindung beschreibt ein Erkennungssystem, insbesondere, jedoch nicht ausschließlich, für die Erfassung der Nähe einer Person relativ zu einem Fahrzeug, mit dem Ziel, Kommunikation zwischen einem Sicherheitssystem des Fahrzeugs und einem von der Person getragenen Transponder auszulösen.

### HINTERGRUND DER ERFINDUNG

Ein Sicherheitssystem für ein Fahrzeug ist entwickelt worden, welches, anstatt durch Fernbetätigung mittels eines Sender-Empfängers oder Transponders, durch die Bewegung eines Türgriffes des Fahrzeugs betätigt werden kann. Ein Betätigungs- oder Entriegelungssignal wird von dem Sicherheitssystem erzeugt, um den mechanischen Verriegelungsmechanismus der Tür auszurücken, wenn die Person den Türgriff ergreift und bewegt. Ein System dieser Art kann auch für den Einlaß in andere verschlossene Bereiche, wie z.B. Privatwohnungen oder gewerbliche Räume, Verwendung finden.

Ein Nachteil des oben genannten Sicherheitssystems ist, daß eine befugte Person, die Einlaß durch die Tür erlangen möchte, den Türgriff schneller ergreift und bewegt, als das Sicherheitssystem in der Lage ist, die Tür zu entriegeln. Dies führt nicht nur zur Frustration der Benutzer dieses Systems, sondern kann auch körperliche Verletzungen von Personen zur Folge haben, wenn die Tür nicht rechtzeitig entriegelt wird.

Ein alternatives Sicherheitssystem ist in der deutschen Patentanmeldung Nr. DE 19620059 beschrieben, in welcher ein kapazitiver Annäherungsschalter in dem Türgriff vorgesehen ist. Der Schalter umfaßt eine Vielzahl von Elektroden für kapazitive Kopplung, so daß die Annäherung der Hand einer Person entdeckt wird, ohne daß eine separate Bewegung des Türgriffs erforderlich ist.

### ZIEL DER ERFINDING

Es ist Ziel der vorliegenden Erfindung, ein verbessertes Erkennungssystem unter Verwendung eines kapazitiven Annäherungsschalters vorzuschlagen.

### BESCHREIBUNG DER ERFINDUNG

Die Erfindung bezieht sich auf ein Erkennungssystem, welches folgende Bestandteile einschließt: eine Schaltvorrichtung mit einem Leiter, der Bestandteil eines Kondensators mit variabler, von der Nähe einer Person abhängiger Kapazität ist, und einen Detektor zur Erfassung von Veränderungen in der Kapazität und zum Erzeugen eines Ausgangssignals, das die Nähe einer Person relativ zu dem Leiter anzeigt, wobei die Schaltvorrichtung des weiteren ein Halteteil umfaßt, welches dafür ausgelegt ist, den Leiter an dem Türgriff zu befestigen, wobei in dem Halteteil auch ein Schalter zur Betätigung seitens einer den Türgriff ergreifenden Person angeordnet ist, um zusätzlich oder alternativ die Nähe der Person anzuzeigen.

In einer weiteren Realisierung ist eine Schaltvorrichtung zum Einsatz in dem oben beschriebenen Erkennungssystem vorgesehen, wobei die Vorrichtung einen Leiter als Bestandteil eines Kondensators zur Wahrnehmung der Nähe einer Person einschließt, sowie einen Schalter und ein Halteteil zur Unterbringung des Leiters und des Schalters und deren Auslegung die Befestigung der Vorrichtung an einem Türgriff ermöglicht.

Bevorzugterweise ist das Halteteil eine Membrane, in welche der Leiter und der Schalter in Juxtaposition zueinander eingebettet sind.

Bevorzugterweise ist der Schalter ein mechanischer Schalter, welcher aus zwei oder mehreren leitfähigen Platten besteht, die durch elektrisches Isoliermaterial getrennt und für relative Verschiebung zur Herstellung eines elektrischen Kontaktes zur Betätigung des Schalters ausgelegt sind. In einer noch mehr bevorzugten Realisierung bildet der Leiter eine der Platten des mechanischen Schalters. Alternativ umfaßt der Schalter einen piezoelektrischen Streifen, welcher ein Wahrnehmungssignal erzeugt, wenn die Person den Türgriff ergreift and eine relative Bewegung eines Teils des Streifens überträgt.

Bevorzugterweise schließt der Detektor einen Oszillator ein, der mit dem Leiter und einem Phasenvergleicher gekoppelt ist, so daß die Kapazitätsveränderung in einer verbundenen Veränderung der Schwingungsfrequenz in dem Oszillator resultiert, um ein phasenmoduliertes Signal in diesem zu erzeugen, das in den Phasenvergleicher eingegeben wird, um ein für die Frequenzwandlung repräsentatives Signal zu erzeugen.

Bevorzugterweise ist der Phasenvergleicher Bestandteil eines Phasenregelkreises und der Detektor umfaßt des weiteren einen Komparator, wobei das Feedback-/Störsignal des Regelkreises in den Komparator zum Vergleich mit einem unteren Grenzpegel eingegeben wird, um das Ausgangssignal zu erzeugen, welches die Nähe der Person anzeigt.

Alternativ, können der Phasenregelkreis und der Komparator durch eine Mikrosteuerung ersetzt werden, welche den Oszillator überwacht, um die ruhende Frequenzcharakteristik zu ermitteln, und welche bei Erfassung einer Abweichung der Frequenzcharakteristiken von einem unteren Grenzpegel nach oben ein die Nähe der Person anzeigendes Ausgangssignal erzeugt. Die Mikrosteuerung kann so programmiert werden, daß sie dem unteren Grenzpegel entsprechend Änderungen in den Frequenzcharakteristiken, die infolge von Temperaturänderungen eingeführt werden, neu einstellt.

Eine weitere Realisierung schlägt ein Sicherheitssystem vor, welches folgende einschließt: eine Steuereinheit, das oben beschriebene Erkennungssystem und ein Schloß; wobei die Steuereinheit nach Entdeckung der Nähe einer Person einen Abfragevorgang in Gang setzt, um die Sicherheitskennung der Person zu überprüfen und das Schloß aufzusperren, wenn die Sicherheitsanforderungen befriedigt werden.

Bevorzugterweise ist das Sicherheitssystem eine Fahrzeugverriegelung oder - außerbetriebsetzung, welche von der Steuereinheit zur Abfrage eines entsprechenden von der Person getragenen Transponders betätigt wird.

### KURZE BESCHREIBUNG DER ZEICHNUNGEN

Die Erfindung ist anschließend mit Bezug auf die beiliegenden Zeichnungen näher beschrieben, wobei das Beispiel in keiner Weise den Umfang der Erfindung beschränkt.
- Figur 1: ist eine schematische Darstellung eines Erkennungssystems gemäß der Erfindung;
- Figur 2: ist eine Schnittzeichnung eines Türgriffes, der in der Erfindung verwendet werden kann; und
- Figur 3: ist eine Vorderansicht des Griffes in Figur 2.

### AUSFÜHRLICHE BESCHREIBUNG EINER BEVORZUGTEN REALISIERUNG DER ERFINDUNG

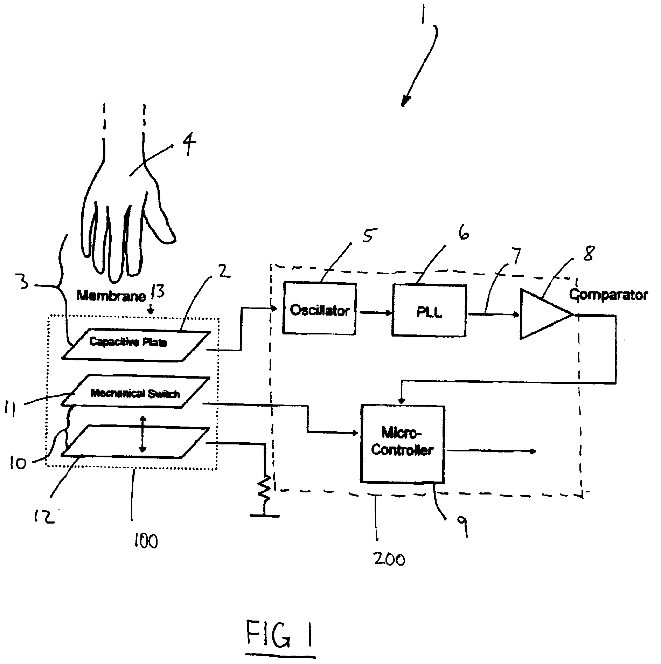

Das Erkennungssystem 1 in Figur 1 umfaßt eine Schaltvorrichtung 100, in welcher ein Leiter in Form einer kapazitiven Platte 2 unterbracht ist, die so ausgelegt ist, daß sie einen Kondensator 3 bildet, wenn sie mit der Hand 4 des Benutzers in Kontakt kommt. Die Platte 2 ist mit dem Detektor 200 verbunden, welcher eine Oszillatorschaltung 5 einschließt, welche wiederum mit einem Phasenvergleicher (nicht gezeigt) eines Phasenregelkreises 6 verbunden ist. Das Ausgangssignal 7 aus dem Phasenregelkreis 6 wird in den Komparator 8 zum Vergleich mit dem unteren Grenzpegel zur Ausgabe an eine Mikrosteuerung 9 eingegeben.

Die Mikrosteuerung 9 ist mit einem mechanischen Schalter 10 verbunden, welcher Bestandteil einer Schaltvorrichtung 100 ist und eine Vielzahl leitfähiger Platten 11, 12, enthält, von welchen eine geerdet ist. Der Schalter schließt bevorzugterweise zwei Platten, wie gezeigt, ein, kann jedoch auch drei, vier oder mehr enthalten. Die Platten sind durch Isoliermaterial (nicht gezeigt) voneinander auf Abstand gehalten and Ihr relative Verschiebung zur Herstellung eines elektrischen Kontaktes zur Betätigung des Schalters ausgelegt. Der mechanische Schalter 10 und die kapazitive Platte 2 sind in Juxtaposition zueinander angeordnet und in einem gemeinsamen Halteteil untergebracht, welches bevorzugterweise eine wasserdichte Membrane 13 ist. Die kapazitive Platte 2 ist als separat von dem mechanischen Schalter gezeigt, kann jedoch stattdessen eine der leitfähigen Platten des Schalters sein.

Die Funktion des Detektors ist, Veränderungen in der Kapazität des Kondensators 3 zu erfassen, wenn die Hand 4 sich der kapazitiven Platte 2 nähert. Die Kapazitätsveränderung bewirkt eine Änderung in der Frequenz des Oszillators 5, welcher ansonsten bei einer konstanten Frequenz oszillieren würde. Zum Beispiel, wenn die Hand 4 sich der Platte 2 nähert, erhöht sich die Kapazität, was wiederum ein Absinken der Oszillator-Frequenz zur Folge hat. Die Frequenzwandlung bewirkt eine Phasenänderung in dem Ausgangssignal des Oszillators 5, welches durch den Phasenvergleicher des Phasenregelkreises 6 geleitet wird, um ein Störsignal oder Feedback-Signal des Phasenregelkreises zu erzeugen, welches in den Komparator 8 zum Vergleich mit einem vorgegebenen unteren Grenzpegel eingegeben wird. Wenn sich also die Hand 4 dem Kondensator 2 nähert, wird ein Störsignal von dem Phasenregelkreis aus erzeugt, und falls dieses Signal den unteren Grenzpegel überschreitet, wird der Komparator ein dementsprechend logisches hohes Ausgangssignal erzeugen, welches der Mikrosteuerung 9 zugeführt wird, beispielsweise zur Aktivierung eines Abfragevorgangs eines Sicherheitssystems.

Im Falle, daß die Kapazitätsveränderung nicht registriert wird, kann der mechanische Schalter durch manuellen Druck betätigt werden, um ein Signal an die Mikrosteuerung weiterzuleiten, um den Abfragevorgang in Gang zu setzen.

Als Alternative zu der Konfiguration Phasenregelkreis und Komparator, kann die Mikrosteuerung stattdessen so ausgelegt werden, den Oszillator über eine bestimmte Zeit zu verfolgen, um die ruhende Frequenzcharakteristik zu ermitteln, und es kann dann ein passender Algorithmus abgearbeitet werden, um die Frequenzcharakteristik und die Frequenzwandlungsrate einzustellen. Eine derartige Anordnung wäre dynamischer dadurch, daß die Mikrosteuerung dann Änderungen in den Frequenzcharakteristiken infolge von Temperaturänderungen überwachen und verfolgen und den unteren Grenzpegel entsprechend einstellen kann.

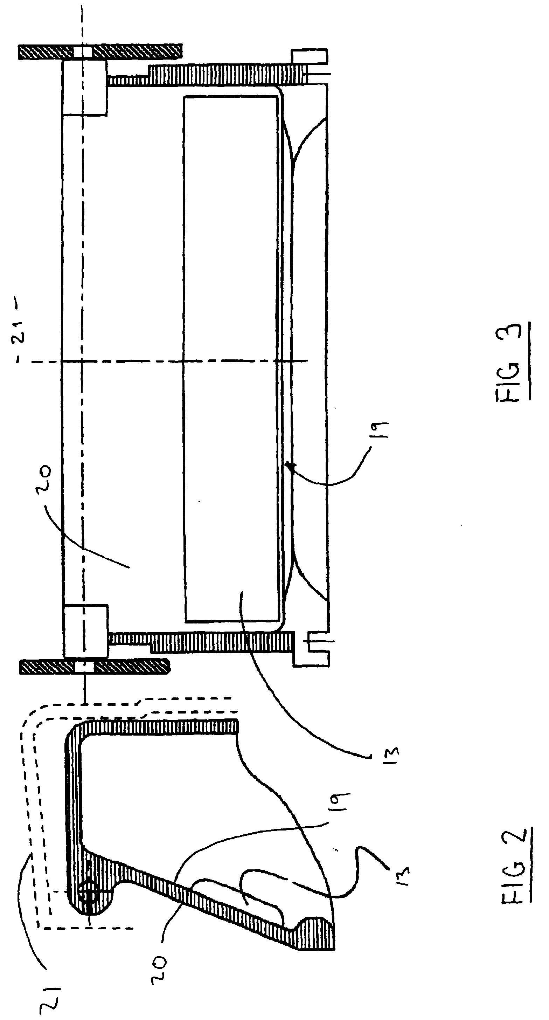

Die Membrane 13, welche die kapazitive Platte 2 und den mechanischen Schalter 10 umhüllt, kann an einer Unterseite 19 eines Türgriffes 20 eines Fahrzeugs 21 befestigt werden, und zwar wie in Figuren 2 und 3 gezeigt. Die kapazitive Platte wird dadurch an einer geeigneten Stelle zwecks Kondensatorkopplung mit der Hand 4 des Benutzers angebracht, und der mechanische Schalter wird an der Stelle angebracht, wo erwartungsgemäß die Finger des Benutzers angelegt werden, um den Türgriff in die geöffnete Stellung zu bringen. In dieser Anordnung kann das Erkennungssystem in ein Sicherheitssystem des Fahrzeugs mit eingeschlossen werden, so daß Wahrnehmung der Nähe der Person oder Betätigung des mechanischen Schalters dazu führen, daß die Mikrosteuerung einen Abfragevorgang aktiviert, wie z.B. durch Erregung eines in dem Fahrzeug befindlichen Transponders, welcher Sicherheitskennungen eines von der Person getragenen zugehörigen Transponders prüft. Wenn die Sicherheitsanforderungen erfüllt sind, würde das System dann zur Entriegelung des Türgriffs 20 in Gang gesetzt, bevor die Hebelbetätigung des Türgriffes selbst in Angriff genommen wird.

Wie sich daraus ersehen läßt, überwindet die frühzeitige Betätigung des Sicherheitssystems das Problem der mit einfacher mechanischer Betätigung des Sicherheitssystems verbundenen Zeitverzögerungen. Die Erfindung bedient sich daher des Vorteils der kapazitiven Annäherungserfassung bei gleichzeitiger Bereitstellung des mechanischen Schalters als Reserve für den Fall, daß die kapazitive Erfassung der Veränderung in der Kapazität versagt, oder in jedem Fall, wenn eine Person Kontakt mit dem Schalter macht. Die Anordnung der kapazitiven Platte und des mechanischen Schalters in Juxtaposition minimalisiert auch das Profil der Vorrichtung 100 und ermöglicht dadurch, daß es auf herkömmliche Weise auf der Unterseite eines Türgriffes oder dergleichen angebracht wird, während die Konfiguration, in welcher die kapazitive Platte Bestandteil des mechanischen Schalters selbst ist, eine Reduzierung der Anzahl der Bauteile der Vorrichtung ermöglicht.

Es sollte auch zur Kenntnis genommen werden, daß das Erkennungssystem in jedem anderen Bereich, wo die Nähe einer Person zur Aktivierung eines Sicherheitssystems benutzt wird, Anwendung finden kann. Des weiteren kann eine zusätzliche kapazitive Platte (nicht gezeigt) eingesetzt werden, um zusammen mit der Platte 2 einen herkömmlichen kapazitiven Annäherungsschalter zu bilden.

Als eine weitere Alternative kann der mechanische Schalter durch einen piezoelektrischen Streifen ersetzt werden, welcher ein Wahrnehmungssignal erzeugt, wenn die Person den Türgriff ergreift und eine relative Bewegung eines Teils des Streifens überträgt.

Dem Fachkundigen werden hierzu eine Vielzahl von Abwandlungen gegenwärtig werden, ohne daß der Umfang der vorliegenden Erfindung, wie sie hiermit unter Bezug auf die beiliegenden Zeichnungen beschrieben wird, überschritten wird.

## Patentansprüche

1. Ein Erkennungssystem, einschließlich einer Schaltvorrichtung mit einem Leiter, der Bestandteil eines Kondensators mit variabler, von der Nahe einer Person abhängiger Kapazität ist, und einen Detektor zur Erfassung von Veränderungen in der Kapazität und zum Erzeugen eines Ausgangssignals, das die Nähe einer Person relativ zu dem Leiter anzeigt, wobei: die Schaltvorrichtung des weiteren ein Halteteil umfaßt, welches daIhr ausgelegt ist, den Leiter an dem Türgriff zu befestigen, wobei in dem Halteteil auch ein Schalter zur Betätigung seitens einer den Türgriff ergreifenden Person angeordnet ist, um zusätzlich oder alternativ die Nähe der Person anzuzeigen.

2. Ein Erkennungssystem gemäß Anspruch 1, in welchem das Halteteil eine Membrane ist, in welcher der Leiter und der Schalter in Juxtaposition zueinander eingebettet sind.

3. Ein Erkennungssystem gemäß Anspruch 1 oder 2, in welchem der Schalter ein mechanischer Schalter ist, welcher aus zwei oder mehreren leitfähigen Platten gebildet ist, die durch elektrisches Isoliermaterial getrennt und für relative Verschiebung zur Herstellung eines elektrischen Kontaktes zur Betätigung des Schalters ausgelegt sind.

4. Ein Erkennungssystem gemäß Anspruch 3, in welchem der Leiter eine der Platten des mechanischen Schalters bildet.

5. Ein Erkennungssystem gemaß Anspruch 1 oder 2, in welchem der Schalter einen piezoelektrischen Streifen einschließt, der ein Wahrnehmungssignal erzeugt, wenn die Person den Türgriff ergreift and eine relative Bewegung eines Teils des Streifens überträgt.

6. Ein Erkennungssystem gemäß einem beliebigen der Ansprüche 1 bis 5, in welchem der Detektor einen Oszillator einschließt, der mit dem Leiter und einem Phasenvergleicher gekoppelt ist, so daß die Kapazitätsveränderung in einer entsprechenden Veränderung der Schwingungsfrequenz in dem Oszillator resultiert, um ein phasenmoduliertes Signal in diesem zu erzeugen das in den Phasenvergleicher eingegeben wird, um ein für die Frequenzwandlung repräsentatives Signal zu erzeugen.

7. Ein Erkennungssystem gemäß Anspruch 6, in welchem der Phasenvergleicher Bestandteil eines Phasenregelkreises ist und der Detektor des weiteren einen Komparator umfaßt, wobei das Feedback-/Störsignal des Regelkreises in den Komparator zum Vergleich mit einem unteren Grenzpegel eingegeben wird, um das Ausgangssignal zu erzeugen, welches die Nähe der Person anzeigt.

8. Ein Erkennungssystem gemäß einem beliebigen der Ansprüche 1 bis 5, einschließlich einer Mikrosteuerung, welche den Oszillator kontrolliert, um die ruhende Frequenzcharakteristik zu ermitteln, und welche bei Erfassung einer Abweichung der Frequenzcharakteristiken von einem unteren Grenzpegel nach oben ein die Nähe der Person anzeigendes Ausgangssignal erzeugt.

9. Ein Sicherheitssystem einschließlich einer Steuereinheit, dem Erkennungssystem gemäß einem beliebigen der Ansprüche 1 bis 7, und einem Schloß, wobei die Steuereinheit nach Wahrnehmung der Nähe einer Person einen Abfragevorgang in Gang setzt, um die Sicherheitskennung der Person zu überprüfen und das Schloß aufzusperren, wenn die Sicherheitsanforderungen befriedigt werden.

10. Ein Sicherheitssystem gemäß Anspruch 9, wobei das Sicherheitssystem ein Fahrzeugverriegelungs- oder Außerbetriebsetzungssystem ist, welches von der Steuereinheit zur Abfrage eines entsprechenden von der Person getragenen Transponders betätigt wird.

11. Eine Schaltvorrichtung, einschließlich einem Leiter als Bestandteil eines Kondensators zur Wahrnehmung der Nahe einer Person, einem Schalter und einem Halteteil, in welchem der Leiter und der Schalter untergebracht sind, und deren Auslegung die Befestigung der Vorrichtung an einem Türgriff ermöglicht.

12. Eine Schaltvorrichtung gemäß Anspruch 11, wobei das Halteteil eine Membrane ist, in welcher der Leiter und der Schalter in Juxtaposition zueinander eingebettet sind.

13. Eine Schaltvorrichtung gemäß Anspruch 11 oder 12, in welcher der Schalter ein mechanischer Schalter ist, der aus zwei oder mehreren leitfähigen Platten besteht, die durch elektrisches Isoliermaterial getrennt und für relative Verschiebung zur Herstellung eines elektrischen Kontaktes zur Betätigung des Schalters ausgelegt sind.

14. Eine Schaltvorrichtung gemäß Anspruch 13, in welcher der Leiter eine der Platten des mechanischen Schalters bildet.

15. Eine Schaltvorrichtung gemäß Anspruch 11 oder 12, in welcher der Schalter einen piezoelektrischen Streifen einschließt, welcher ein Wahrnehmungssignal erzeugt, wenn die Person den Türgriff ergreift and eine relative Bewegung eines Teils des Streifens überträgt.
